# EUROPEAN PATENT APPLICATION

(11) **EP 3 261 128 A1**
(43) Date of publication of application: **27.12.2017**
(21) Application number: 16175959.2
(22) Date of filing: 23.06.2016
(51) Int. Cl.: H01L 29/786, H01L 27/12

(54) **VERTICAL FIELD-EFFECT TRANSISTOR, A METHOD FOR ITS MANUFACTURE, ITS USE, AND ELECTRONICS COMPRISING SAID FIELD-EFFECT TRANSISTOR**

(71) Applicant: Karlsruher Institut für Technologie, 76131 Karlsruhe (DE)
(72) Inventor: DASGUPTA, Subho, 76133 Karlsruhe (DE); HAHN, Horst, 64342 Seeheim-Jugenheim (DE); REITZ, Christian, 76344 Eggenstein-Leopoldshafen (DE); VON SEGGERN, Falk, 76131 Karlsruhe (DE); BABY, Tessy Theres, 76344 Eggenstein-Leopoldshafen (DE)
(74) Representative: Herzog, Fiesser & Partner Patentanwälte PartG mbB

(57) **Abstract**

The present invention relates to a vertical field-effect transistor (110) comprising
- an arrangement having a first electrode layer (112), a second electrode layer (122), and a porous semiconductor layer (118), wherein the porous semiconductor layer (118) is located vertically between the first electrode layer (112) and the second electrode layer (122);
- an insulating layer (128) comprising a dielectric layer and/or a ferroelectric layer; and
- a gate electrode layer (134);
wherein the insulating layer (128) covers the arrangement in a manner that the gate electrode layer (134) is physically and electrically separated from the first electrode layer (112), the second electrode layer (122), and the porous semiconductor layer (118).

The vertical field-effect transistor is expected to exhibit high current densities in the order of MA/cm² or more, may provide higher switching speeds compared to conventional field-effect transistors. The present invention may, thus, open new opportunities for an integration of field-effect transistors in a third dimension by stacking at least two vertical field-effect transistors on top of each other.

## Description

### Field of the invention

The present invention relates to a vertical field-effect transistor, an assembly comprising at least two of said vertical field-effect transistors, a method for its manufacture, its use, and electronics comprising said field-effect transistor.

### Related art

A field-effect transistor (FET) comprises an arrangement of a pair of electrodes and a semiconductor layer, which is also denoted as a "channel" since it is located between the pair of the electrodes, also commonly denominated as "drive electrodes" or, separately, as "source electrode" and "drain electrode". This arrangement allows applying an electric field using a separate gate electrode and gate oxide, wherein the gate oxide may also be denoted as "insulator" or "dielectric", in order to polarize the semiconductor layer and to accumulate or deplete charge carriers therein, thus, allowing control over the electrical conductivity by controlling the population of at least one kind of charge carriers, i.e. electrons or holes. In a conventional FET, the arrangement exhibits a transistor geometry in which both drive electrodes and the semiconductor layer are placed on a common substrate. In contrast hereto, the transistor geometry in a vertical FET comprises the drive electrodes being located on top of each other, thereby sandwiching the semiconductor layer in vertical direction.

Devices comprising a vertical FET have been already proposed and realized. In accordance with references [1]-[3], the vertical FET is obtained by an orthogonal rotation of a known thin film transistor. Alternatively, as described in references [4] and [5], vertical electronic transport in vertically aligned nanowire transistors has been demonstrated. Further, in reference [6] a pseudo-vertical geometry is used, wherein one of the drive electrodes is extremely thin, thus, allowing the applied field to penetrate the thin metal electrode in order to be capable of polarizing the semiconductor layer.

EP 2 811 525 A1 discloses an electrochemically-gated vertical FET in which the channel length is independent from the printing resolution. The vertical FET comprises an arrangement placed on top of a substrate which consists of a first electrode, a second electrode and a transistor channel, located between the two electrodes, an electrolyte, covering the transistor channel completely, and a gate electrode. The first electrode, comprising a first solid or porous metallic conducting body, is placed on top of the substrate. The transistor channel, comprising a porous semiconducting material, is placed on top of the first electrode, partially covering the first electrode. The second electrode, comprising a second solid or porous metallic conducting body, is placed on top of the transistor channel which is placed on top of the first electrode, at least partially covering the transistor channel. The electrolyte penetrates at least through the transistor channel down to the first electrode while leaving a part of each electrode uncovered. The gate electrode, comprising a third solid or porous metallic conducting body, is placed in contact with the electrolyte but without any contact to the arrangement.

In principal, vertical field-effect transistors are adapted to provide very large on-currents, transconductance, and power densities. In addition, vertical field-effect transistors promise a high integration density. However, no reliable vertical FETs capable of providing high current densities and integration densities together with high operation frequency and long-term reliable performance are currently known. In fact, no report of a vertical FET device is available, in which the vertical FET may take full advantage of a bulk transistor channel to offer extremely high current density, easy fabrication, and reliable device performance.

### Problem to be solved

It is therefore an objective of the present invention to provide a vertical field-effect transistor (FET), an assembly comprising at least two of said vertical FETs, a method for its manufacture, its use, and electronics comprising said FET, which at least partially overcome the above-mentioned problems of the state of the art.

It is a particular objective of the present invention to provide a vertical FET which does not only allow a vertical current transport but is also adapted to take full advantage of the vertical geometry of a semiconductor layer to accumulate charge carriers in a bulk amount of a semiconductor material in order to achieve a high current density.

It is a further objective of the present invention to move from a standard two-dimensional geometry of the FET device to a three-dimensional (bulk) FET device.

It is a further objective of the present invention to provide a particular method and device allowing a three-dimensional gating ability of an electrolyte to be mimicked with organic and/or inorganic gate dielectrics and/or gate ferroelectrics.

### Summary of the invention

This problem is solved by a vertical field-effect transistor (FET), an assembly comprising at least two of said vertical FETs, a method for its manufacture, its use, and electronics comprising said FET, each comprising the features of the related independent claims. Preferred embodiments, which might be realized in an isolated fashion or in any arbitrary combination, are listed in the dependent claims.

As used in the following, the terms "have", "comprise" or "include" or any arbitrary grammatical variations thereof are used in a non-exclusive way. Thus, these terms may refer to both a situation in which, besides the feature introduced by these terms, no further features are present in the entity described in this context and to a situation in which one or more further features are present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

Further, as used in the following, the terms "preferably", "more preferably", "particularly", "more particularly", or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in this way with other features of the invention.

In a first aspect, the present invention relates to a vertical field-effect transistor (FET), wherein the vertical FET comprises:
- an arrangement having a first electrode layer, a second electrode layer, and a porous semiconductor layer, wherein the porous semiconductor layer is located vertically between the first electrode layer and the second electrode layer;
- an insulating layer comprised of a dielectric layer and/or a ferroelectric layer; and
- a gate electrode layer covering the insulating layer;
wherein the insulating layer covers the arrangement in a manner that the gate electrode layer is physically and electrically separated from the first electrode layer, the second electrode layer, and the semiconductor layer.

Being an FET, the vertical FET is a device comprising an arrangement of a pair of electrodes which are, commonly denominated as "drive electrodes" or, separately as "source electrode" and "drain electrode" and a semiconductor layer, also denoted as a "channel". As used herein, the term "arrangement" refers to a presence of the pair of the drive electrodes and the semiconductor layer, which are closely located with respect to each other as described below in more detail. As generally used, the term "electrode" refers to an electrically conducting material, wherein the electrically conducting material may, preferably, be selected from a metallically conducting organic material or a metallically conducting inorganic material, in particular from a noble metal. However, other kinds of metals, alloys, or semi-metals, conducting oxides and conducting polymers may also be considered.

According to the present invention, the drive electrodes are provided in form of electrode layers, i.e. as a first electrode layer and as a second electrode layer. As used herein, the terms "layer" or "layered structure" may refer to a planar embodiment of the drive electrodes, wherein the planar embodiment refers to a three-dimensional body having extensions in two lateral directions which exceed the extension in a third direction. In particular, the first electrode layer and the second electrode layer may, thus, be arranged in a parallel direction with respect to each other, thus, being vertically separated from each other by a distance, wherein the distance may amount from 5 nm to 5 µm, preferably from 20 nm to 100 nm. The thickness of the electrode layers may, preferably, be in a range from 5 nm to 1 µm

Thus, in the vertical FET, the electrode layers are vertically stacked with respect to each other. Consequently, one of the drive electrodes may be located on top of the other drive electrode in a manner that the volume between the drive electrodes may be filled with the semiconductor layer which may, preferably, be sandwiched between the pair of the electrode layers. As used herein, the term "top" may refer to one side of a layer on which another layer may fully or partially be located while the other side of the layer, which may also be denoted by the term "bottom", may form a basis or may, alternatively, fully or partially be located on top of a further layer. Thus, on the top side of the first electrode layer the semiconductor layer may fully or partially be located while the bottom side of the first electrode may fully or partially be located on top of a substrate. Similarly, the bottom side of the second electrode layer may fully or partially be located on top of the semiconductor layer while the top side of the second electrode may fully or partially be covered by the insulating layer. In a particular embodiment, the first electrode layer may be located on an insulating substrate. As further used herein the "substrate" may refer to a usually planar body on top of which at least one layer may be placed, in particular for obtaining a more complex device. With regard to the present invention, the substrate layer may comprise an electrically insulating material. Thus, the arrangement according to the present invention is in contrast to a conventional FET, in which both drive electrodes and the semiconductor layer are placed on a common substrate being located next to each other comprising an essentially planar device geometry.

Further, the volume between the electrode layers is filled, at least partially, by the semiconductor layer which may, therefore, have a thickness that may correspond to the vertical separation between the related drive electrodes. Herein, the porous semiconductor layer may, comprise an inorganic semiconducting material or an organic semiconducting material. Preferably, the inorganic semiconducting material may be selected from an oxide semiconductor, in particular, selected from the group consisting of tin dioxide (SnO₂), indium oxide (In₂O₃,) and zinc oxide (ZnO) or a mixture thereof. In addition, the inorganic material may comprise other metals as dopants, such as Ga or Hf. Alternatively, the oxide semiconductor may be a hole conducting oxide semiconductor, such as tin monoxide (SnO), copper(I) oxide (Cu₂O), copper(II) oxide (CuO), or cupper aluminum oxide (CuAlO₂). Further, the inorganic semiconducting material may be electron conducting (n-type) or hole conducting (p-type) and be selected from other inorganic semiconductors, in particular, from silicon (Si), germanium (Ge), II-VI semiconductors, or III-V semiconductors. Preferably, the organic semiconducting material may be selected from a conjugated organic system, in particular from pentacene, poly(3-hexylthiophen-2,5-diyl) (P3HT), poly-3,4-ethylendioxythiophen (PEDOT), or poly(2,5-bis(3-hexadecylthiophen-2-yl)thieno[3,2-b]-thiophene (PBTTT), or any mixture thereof. However, other kinds of semiconducting materials, such as a pure carbon based material, may also be feasible.

Further, the porous semiconductor layer may comprise a plurality of pores. Herein, the term "pores" may refer to a plurality of small volumes within the semiconductor layer which may be free of semiconducting material but partially or fully surrounded by the semiconducting material. The pores in the porous semiconductor layer may, preferably, have a predominant pore size from 5 nm to 5 µm, preferably from 15 nm to 100 nm, wherein the thickness of the porous semiconductor layer may, however, exceed the size of each of the pores. In this regard, the pores may exhibit a pore size distribution which can be narrow or wide. According to the predominant pore size, the porous semiconductor layer may be considered as a nanoporous semiconductor layer or a microporous semiconductor layer. As a result, the porous semiconductor layer may exhibit a large ratio of the surface area to volume as provided by the areas of the semiconducting material adjoining the pores. Herein, the pores of the porous semiconductor layer may be free of other material or, as described below in more detail, filled with a different material apart from the semiconducting material. As generally used, the nanoporous layer may predominantly comprise nanoscale pores having a pore size of 1 nm to 100 nm while the microporous layer may predominantly comprise microscale pores having a pore size above 100 nm up to 10 µm. In a particularly preferred embodiment, the pores of the porous semiconductor layer may exhibit a pore size from 15 nm to 100 nm, thus, the porous semiconductor being a nanoporous semiconductor.

Further, the semiconductor layer may comprise the semiconducting material as nano-sized interconnected domains, wherein the domains may together constitute the nanoporous semiconductor material. As used herein, the term "domain" may refer to a plurality of nano-sized particles comprising the semiconducting material which can be provided in any regular or irregular form, such as ribbon-like, a tape-like, a rod like, or a ligament-like structure, the structure having a large surface area. As a result of providing the semiconducting material in the form of the nano-sized domains and/or the porous structure, charge accumulation in the semiconductor layer may, thus, occur over all available surfaces.

Further, the vertical FET according to the present invention comprises an insulating layer, which may also be denoted as "insulator layer", wherein the insulating layer is adapted to cover the arrangement as described above. For this purpose, the insulating layer comprises an electrically insulating material selected from a dielectric layer and/or a ferroelectric layer. In order to place the insulating layer on the arrangement, the drive electrodes and the semiconducting channel may be exposed to a film growth technique, i.e. a deposition technique that can be adapted to grow the insulating layer for covering the arrangement in a conformal manner, preferably, to an atomic layer deposition (ALD) technique, or to a chemical vapor deposition (CVD) technique.

In a preferred embodiment, the dielectric layer may comprise a dielectric material selected from the group consisting of alumina (Al₂O₃), silicon dioxide (SiO₂), and high-k dielectric materials, including hafnium dioxide (HfO₂), zirconium dioxide (ZrO₂), titanium dioxide (TiO₂), and tantalum pentoxide (Ta₂O₅). As generally used, the term "high-k dielectric material" refers to a compound exhibiting a high dielectric constant, wherein the dielectric constant of silicon dioxide (SiO₂) is used as a reference. However, other kinds of dielectric materials, in particular, organic dielectric materials, such as poly(vinyl alcohol) (**PVA**) or poly(methyl methacrylate) (**PMMA**), preferably, in form of self-assembled dielectric monolayers or self-assembled nanodielectrics, may also be feasible. Alternatively, the insulating layer of the vertical FET according to the present invention is a ferroelectric layer. Preferably, the ferroelectric layer may comprise a ferroelectric material, preferably, selected from the group consisting of barium titanate (BaTiO₃), strontium titanate (SrTiO₃), barium strontium titanate ([BaₓSr₁₋ₓ]TiO₃, wherein 0 < *x* < 1), lead titanate (PbTiC₃), lead zirconate (PbZrO₃), and lead zirconium titanate (PZT; Pb[ZrₓTi₁₋ₓ]O₃, wherein 0 < *x* < 1). Further, organic ferroelectrics, such as polyvinylidene fluoride (**PVDF**) or poly[(vinylidenefluoride-co-trifluoroethylene] (P**(VDF-TrFE**)), may also be feasible.

According to the present invention, the insulating layer is adapted to cover the arrangement, comprising the first electrode layer, the second electrode, and the porous semiconductor layer, in a manner that a further metallic layer which is described below in more detail is physically and electrically separated from any partition of the arrangement, in particular from any one of the first electrode layer, the second electrode, and the porous semiconductor layer. Herein, the thickness of the deposited insulating layer may, preferably, be in the range from 5 nm to 1 µm. As generally used, the term "physically and electrically separated" describes a respective location of two related objects being located with respect to each other in a manner that they do neither have a common contact point or a common contact area nor that no charge carriers may be moving between the objects.

Thus, the vertical FET comprises the further metallically conducting layer which is configured to form a gate electrode layer, which covers an area of the insulating layer within a predefined window. For obtaining the metallically conducting layer, a metal or an inorganic or organic metallically conducting material may be grown in order to cover the insulating layer to be capable of working as the gate electrode layer. As generally used, the term "gate electrode layer" refers to a third electrode in the FET having a layered structure being adapted for applying an electrical field to the semiconductor layer in order to polarize it, thus, allowing control of a carrier accumulation and/or depletion of at least one kind of charge carriers, i.e. electrons or holes, in the semiconductor layer. Upon application of a gate potential, each of the nano-sized domain in the semiconductor can therefore have a charge accumulation over all available surfaces, and, at an ON state, the device may be capable of carrying large currents in the order of MA/cm² or more. For the purpose of providing the gate electrode layer, a deposition technique capable of providing a conformal layer on irregular surfaces, preferably an atomic layer deposition (ALD) technique, or a chemical vapor deposition (CVD), may be applied in a manner that it fully or partially covers the previously grow insulating layer in a manner that no physical or electrical contact to any partition of the arrangement, i.e. neither to any one of the drives electrodes nor to the semiconductor layer, may be achieved. The thickness of the metallic layer being adapted as the gate electrode material may, preferably, be in a range from 5 nm to 1 µm.

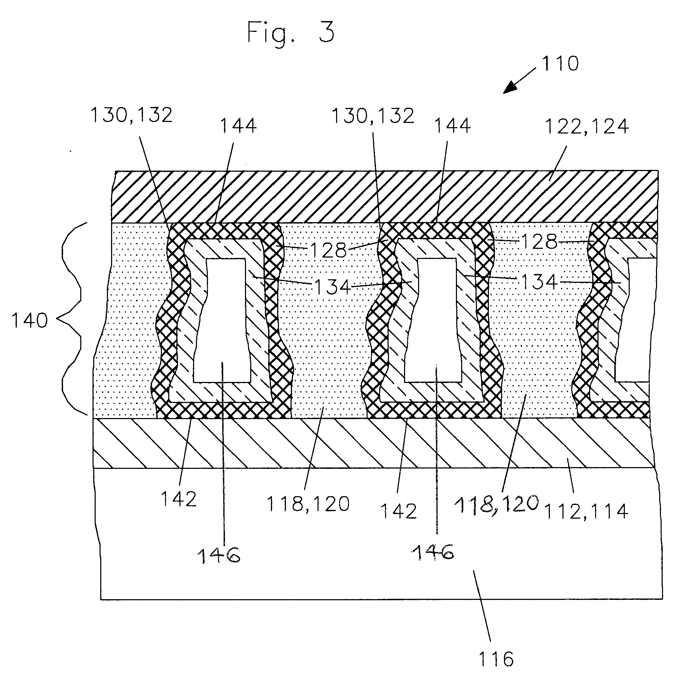

As a result, the nanostructured composite material sandwiched between the drive electrodes, i.e. the source electrode and the drain electrode, is composed of the porous semiconductor, the insulating layer and the metallically conducting material used for the gate electrode. Thus, the pores which are present in the porous semiconducting material may be fully sealed. Alternatively, the porous semiconducting material may still exhibit at least some at least partially empty pores thereafter, such as illustrated below in Figure 3, inside a coverage provided by the gate electrode.

In addition to the already mentioned deposition techniques, structuring techniques, such photolithography or electron beam lithography, physical and/or chemical etching of layers and/or dispensing techniques, such as printing methods, may be applied during manufacturing of the vertical FET.

In a further aspect, the present invention relates to an assembly which comprises at least two individual vertical FETs as described elsewhere herein. As an advantage of the said vertical FET architecture, vertical stacking of the vertical FETs may, thus, allow obtaining vertically-grown logic elements and/or circuit elements. In this case, the vertical FETs may be vertically stacked by placing insulating layers between adjacent vertical stacks. Alternatively, individual vertical FETs may be connected by applying electrically conducting paths and/or lines.

In a preferred embodiment, the two adjoining individual vertical FETs are located on top of each other in a manner that they are adapted to share a common electrode layer. By way of example, a first vertical FET may comprise a source electrode as a bottom electrode and a drain electrode as a top electrode. In this example, a second vertical FET located on top of the first vertical FET may consider the drain electrode of the bottom FET as the source electrode or the bottom electrode wherein both the top electrode of the first vertical FET and the bottom electrode of the second vertical FET may be the same electrode body. However, other examples may also be feasible. Thus, a number of known logic gates and circuit elements may be realized by stacking individual vertical FETs in vertical direction. As a result, the vertical stacking of two or more FETs may be capable of increasing a device packing density and may, thus, enable a larger integration density of transistors on a single chip.

In a further aspect, the present invention relates to a method for manufacturing a vertical field-effect transistor (FET). Herein, the method comprises the following steps a) to d) which are, preferably, performed in the given order, starting with step a), continuing with step b) and, subsequently, with step c), and finishing with step d), wherein, however, additional steps, either mentioned in this document or not, may be incorporated.

Thus, the method for manufacturing the vertical FET comprises the following steps:
a) providing a first electrode layer;
b) preparing an arrangement by placing a semiconductor layer on top of the first electrode layer and, subsequently, placing a second electrode layer on top of the semiconductor layer, wherein the semiconductor layer is a porous semiconductor layer;
c) growing an insulating layer, the insulating layer comprising a dielectric layer and/or a ferroelectric layer, in a manner that first exposed areas of the porous semiconductor layer, an accessible exposed area of the first electrode layer and an accessible exposed area of the second electrode layer within a first window is covered by the insulating layer; and
d) growing a metallically conducting layer configured to form a gate electrode layer covering second exposed areas of the insulating layer within a second window;
wherein the insulating layer is grown during step c) in a manner that the metallically conducting layer which is grown during step d) remains physically and electrically separated from the first electrode layer, the second electrode layer, and the semiconductor layer.

With particular regard to step b), it may be indicated here that the semiconductor layer is a porous semiconductor layer as described above in more detail. In accordance with the present invention, the porous semiconductor layer may be obtained by providing a porous semiconductor layer to be placed on top of the first electrode layer. Alternatively, a precursor layer may be placed on top of the first electrode layer, which may, successively, be treated in order to obtain the porous semiconductor layer. By way of example, a curing step may be applied, wherein the curing step may be adapted to modify the precursor semiconducting layer in order to open the pores.

In the process of manufacturing the vertical FET, other method steps, preferably heating, photonic curing, or material sintering techniques may be used. In addition, the vertical FET as manufactured according to the present invention may or may not be encapsulated with a suitable organic and/or inorganic encapsulation material.

For further details of the manufacturing process, reference may be made to the description of the vertical FET elsewhere in this document.

In a further aspect, the present invention relates to a use of a vertical field-effect transistor (FET) as described elsewhere in this document in high-density device integration and high-power electronics. In particular, the vertical FET may be used for providing considerably large current densities, transconductance, and power density in the ON state of the vertical FET. In particular, it is expected that the vertical FET as described here may be capable of carrying large currents in the order of MA/cm² or more in the ON state. As a result, the vertical FET according to the present invention may, moreover, exhibit a large ON/OFF ratio with respect to the mentioned quantities.

In a preferred embodiment, such vertical FETs may find use in all sorts of control circuits, in particular associated with energy storage, wherein FETs may be required to handle high current densities and/or power densities.

In a further aspect, the present invention relates to electronics which comprises a vertical field-effect transistor (FET) as described elsewhere in this document. In contrast to known thin film transistor devices, the obtained devices having a bulk transistor channel, which may be controllable by the field effect, may be capable of providing considerably large current densities, which appears not to be possible with known transistor devices..

The vertical field-effect transistor (FET) as described herein provides a number of additional advantages compared to the electrolyte-gated FETs as disclosed in EP 2 811 525 A1. Herein, the vertical FET may provide higher switching speeds compared to electrolyte-gated FETs, wherein the higher switching speeds may, in particular, be due to the use of dielectric materials or ferroelectric materials as gate oxides. Further, the vertical FET is expected to exhibit high current densities in the order of MA/cm² or more. Further, the vertical FET opens new opportunities for integration in a third dimension by stacking respective devices on top of each other. An all solid processing using stable and commercially available technologies, e.g. atomic layer deposition or lithography, may lead to a long-term stability of the vertical FETs as manufactured according to the present invention. In addition, the present invention relating to dielectric and/or ferroelectric-gated vertical FETs which promise that electrical and/or thermal reliability may not be of any real concern. Summarizing, the vertical FET as described herein appears to be an easy-to-fabricate dielectric and/or ferroelectric-gated bulk transistor with vertical device architecture.

### Short description of the Figures

Further optional features and embodiments of the invention will be disclosed in more detail in the subsequent description of preferred embodiments, preferably in conjunction with the dependent claims. Therein, the respective optional features may be realized in an isolated fashion as well as in any arbitrary feasible combination, as the skilled person will realize. It is emphasized here that the scope of the invention is not restricted by the preferred embodiments.

In the Figures:
- Figure 1: illustrates a preferred embodiment of a vertical field-effect transistor (FET) in a functional top view;
- Figure 2: illustrates the preferred embodiment of the vertical FET of Figure 1 in a side view; and
- Figure 3: illustrates the preferred embodiment of the vertical FET of Figure 1 in an enlarged side view.

### Detailed description of the embodiments

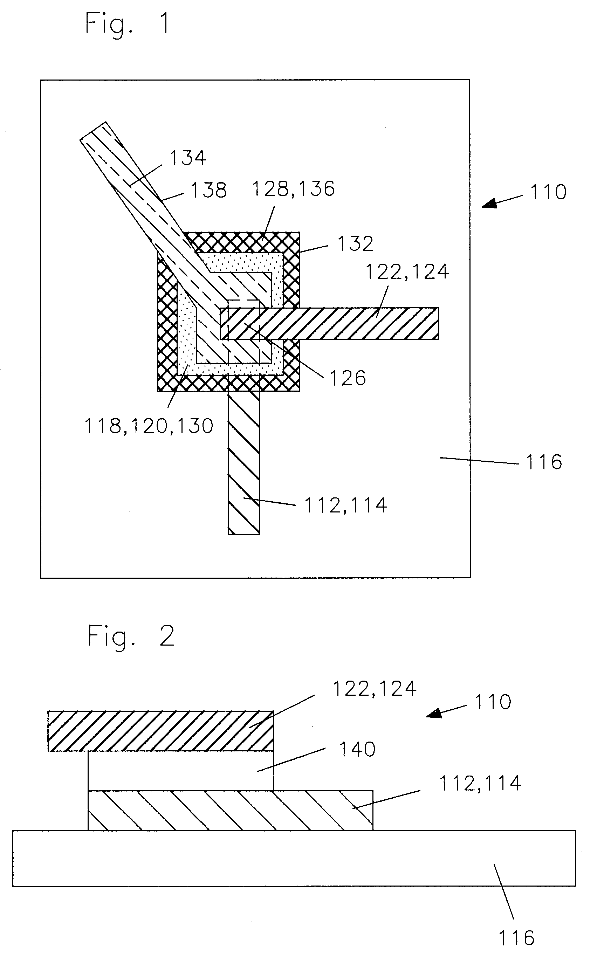

Figure 1 illustrates a preferred embodiment of a vertical field-effect transistor (FET) 110 being displayed in a functional top view. As shown in Figure 1, a first electrode layer 112, which may, in this exemplary embodiment, be accomplished as a source electrode 114, is located on top of a substrate 116. Further, a porous semiconductor layer 118 is placed on the first electrode layer 112 in a manner that it partially covers the first electrode layer 112. Herein, the porous semiconductor layer 118 may, preferably, be provided as a nanoporous semiconductor layer 120 comprising tin oxide (SnO₂), wherein the pores may have predominant pore sizes from 15 nm to 100 nm. However, further kinds of semiconducting materials, in particular the semiconducting materials as presented above, may also be feasible. Further, a second electrode layer 122, which may, in this exemplary embodiment, be accomplished as a drain electrode 124, is located on top of the porous semiconductor layer 118. As a result, at least a partition 126 of the porous semiconductor layer 118 is sandwiched between the first electrode layer 112 and the second electrode layer 122. Both the first electrode layer 112 and the second electrode layer 122 comprise an electrically conducting material, preferably, be selected from a metallically conducting inorganic or organic material, in particular from a noble metal. However, other kinds of metals, alloys, semi-metals, conducting oxides, or conducting polymers may also be feasible.

Further, the vertical FET 110 is equipped with an insulating layer 128 adapted to cover all first exposed areas 130 of the porous semiconductor 118 and also a partition of each of the first electrode layer 112 and the second electrode layer 122 that are available within a first window 132. Herein, the first window 132 may have a lateral size which may exceed the lateral size of the first exposed areas 130 of the porous semiconductor 118. Thus, although the insulating layer 128 finally covers the porous semiconducting layer 118 completely, the porous semiconducting layer 118 is, nevertheless, still kept visible in Figure 1 in order to demonstrate its presence in the vertical FET 110 according to the present invention.

As described above, the insulating layer 128 may constitute a dielectric layer, preferably, comprising alumina (Al₂O₃), silicon dioxide (SiO₂), or a high-k dielectric materials, in particular, hafnium dioxide (HfO₂), zirconium dioxide (ZrO₂), titanium dioxide (TiO₂), and tantalum pentoxide (Ta₂O₅). Alternatively, the insulating layer 128 may constitute a ferroelectric layer, preferably, a barium and/or strontium titanate ([BaₓSr_{1-x]}TiO₃, wherein 0 ≤ x ≤ 1). However, further kinds of dielectric or ferroelectric materials, respectively, may also be feasible, particularly the materials as presented above. The insulating layer 128 may, preferably, be obtained by applying a conformal growth of one or more selected dielectric or ferroelectric materials, respectively, within the first window 132.

Further, the vertical FET 110 is equipped with a gate electrode layer 134 which is electrically separated from the first electrode layer 112, the second electrode layer 122, and the porous semiconductor layer 118 by the insulating layer 128. Herein, the gate electrode layer 134 may, preferably, be provided by a conformal growth of a layer comprising a metal or an inorganic or organic metal-like material adapted to form the gate electrode 134. According to the present invention, the gate electrode 134 covers a part of the exposed area 136 of the insulating layer 128 which are available within a second window 138 as defined by a form of the gate electrode 134.

Figure 2 illustrates the preferred embodiment of the vertical FET 110 of Figure 1 displayed in a side view. As shown in Figure 2, the first electrode layer 112 comprising the source electrode 114 is placed on the substrate 116 while the second electrode layer 122 comprising the drain electrode 124 is placed on an ensemble 140, comprising the porous semiconductor layer 118 covered by the insulating layer 128 and the gate electrode layer 134 which is separated within the ensemble 140 from the first electrode layer 112, the second electrode layer 122, and the porous semiconductor layer 118 by use of the insulating layer 128.

Figure 3 illustrates the preferred embodiment of the FET 110 of Figure 1 displayed in an enlarged side view. Herein, the first electrode layer 112 comprising the source electrode 114 is placed on the substrate 116 while the second electrode layer 122 comprising the drain electrode 124 is placed on the ensemble 140. For this purpose, a metal organic layer which, acting as a precursor layer, may later be transformed into the porous semiconductor layer 118 may be placed on the first electrode layer 112. Thereafter, the second electrode layer 122 may be placed on the metal organic layer. Subsequently, a curing step may be executed, wherein the curing step may be adapted for converting the precursor layer into the desired porous semiconductor layer 118 which comprises domains as described above in more detail. Although a partition of the second electrode layer 122 at the top may be free standing, it may not collapse or make a shortcut with first electrode layer 112 at the bottom.

As further illustrated in Figure 3, the insulating layer 128 in the ensemble 140 covers all the first exposed area 130 of the porous semiconductor layer 118 and also an accessible exposed area 142 of the first electrode layer 112 and an accessible exposed area 144 of the second electrode layer 122 which are available within the first window 132. For this purpose, the insulating layer 128 may, preferably, be grown by using atomic layer deposition (ALD), such that growth species in the gaseous phase may enter into accessible pores of the arrangement and may, thus, cover the accessible exposed areas 142, 144 of the arrangement.

Further in the ensemble 140, the gate electrode layer 134 covers all the second exposed area 136 of the insulating layer 128 which is accessible within the second window 138. For this purpose, a metallically conducting layer may, preferably, be grown by again using atomic layer deposition (ALD), such that the growth species in gas phase may enter and cover the accessible areas. As a result, some at least partially empty pores 146 may remain thereafter in the porous semiconducting layer 118. Herein, the at least partially empty pores 146 are schematically depicted in Figure 3 in form of white boxes drawn inside the coverage as provided by the gate electrode layer 134. Consequently, the insulating layer 128 is arranged in a manner that the gate electrode layer 134 is, concurrently, electrically separated from all the first electrode layer 112, the second electrode layer 122, and the porous semiconductor layer 118.

### Literature

- [1]: Johnston, D. E., Yager, K. G., Nam, C. Y., Ocko, B. M. & Black, C. T. One-Volt Nano Lett. 12, 4181-4186 (2012).
- [2]: Lemaitre, M. G. et al. ACS Nano 6, 9095-9102 (2012).
- [3]: Stutzmann, N., Friend, R. H. & Sirringhaus, H. Science 299, 1881-1884 (2003).
- [4]: Chen, L., Fung, W. Y. & Lu, W. Nano Lett. 13, 5521-5527 (2013).
- [5]: J. Goldberger, A. I. Hochbaum, R. Fan, and P. Yang, Nano Letters, 6, 2006, 973
- [6]: Yu, W. J. et al. Nat. Mater. 12, 246-252 (2013).

### Reference signs

- 110: vertical field-effect transistor (FET)
- 112: first electrode layer
- 114: source electrode
- 116: substrate
- 118: porous semiconductor layer
- 120: nanoporous semiconductor layer
- 122: second electrode layer
- 124: drain electrode
- 126: partition of the porous semiconductor layer
- 128: insulating layer
- 130: first exposed area
- 132: first window
- 134: gate electrode layer
- 136: second exposed areas
- 138: second window
- 140: ensemble
- 142: accessible exposed area of the first electrode layer
- 144: accessible exposed area of the second electrode layer
- 146: at least partially empty pores

## Claims

1. A vertical field-effect transistor (110) comprising
- an arrangement having a first electrode layer (112), a second electrode layer (122), and a porous semiconductor layer (118), wherein the porous semiconductor layer (118) is located vertically between the first electrode layer (112) and the second electrode layer (122);
- an insulating layer (128) comprising a dielectric layer and/or a ferroelectric layer; and
- a gate electrode layer (134);
wherein the insulating layer (128) covers the arrangement in a manner that the gate electrode layer (134) is physically and electrically separated from the first electrode layer (112), the second electrode layer (122), and the porous semiconductor layer (118).

2. The vertical field-effect transistor (110) according to the preceding claim, wherein the first electrode layer (112) is located on an insulating substrate (116).

3. The vertical field-effect transistor (110) according to any one of the preceding claims, wherein the porous semiconductor (118) layer comprises a porous semiconducting material, wherein the porous semiconducting material is selected from the group consisting tin dioxide (SnO₂), indium oxide (In₂O₃,) zinc oxide (ZnO), tin monoxide (SnO), copper(I) oxide (Cu₂O), copper(II) oxide (CuO), cupper aluminum oxide (CuAlO₂), silicon (Si), germanium (Ge), II-VI semiconductors, III-V semiconductors, pentacene, poly(3-hexylthiophen-2,5-diyl) (**P3HT**), poly-3,4-ethylendioxythiophen (**PEDOT**), poly(2,5-bis(3-hexadecylthiophen-2-yl)thieno [3,2b]thiophene (**PBTTT**), mixtures and dopants thereof.

4. The vertical field-effect transistor (110) according to the preceding claim, wherein the semiconducting material is provided in form of nano-sized interconnect domains, together constituting a nanoporous semiconductor material.

5. The vertical field-effect transistor (110) according to any one of the preceding claims, wherein the porous semiconductor layer (118) comprises pores, wherein the pores exhibit a pore size from 5 nm to 5 µm.

6. The vertical field-effect transistor (110) according to any one of the preceding claims, wherein the first electrode layer (112) and the second electrode layer (122) are vertically separated from each other by a distance, wherein the distance amounts from 10 nm to 5 µm.

7. The vertical field-effect transistor (110) according to any one of the preceding claims, wherein the insulating layer (128) is a dielectric layer, wherein the dielectric layer comprises a dielectric material selected from the group consisting of alumina (Al₂O₃), silicon dioxide (SiO₂), high-k dielectric materials, including hafnium dioxide (HfO₂), zirconium dioxide (ZrO₂), titanium dioxide (TiO₂), and tantalum pentoxide (Ta₂O₅), poly(vinyl alcohol) (**PVA**), and poly(methyl methacrylate) (**PMMA**), and/or wherein the insulating layer is a ferroelectric layer, wherein the ferroelectric layer comprises a ferroelectric material selected from the group consisting of barium titanate (BaTiO₃), strontium titanate (SrTiO₃), barium strontium titanate ([BaₓSr₁₋ₓ] TiO₃, 0 < *x* < 1), lead titanate (PbTiO₃), lead zirconate (PbZrO₃), lead zirconium titanate (PZT; Pb[ZrₓTi₁₋ₓ] O₃, 0 < *x* < 1), polyvinylidene fluoride (**PVDF**), and poly[(vinylidenefluoride-co-trifluoroethylene] (**P(VDF-TrFE)**).

8. The vertical field-effect transistor according to any one of the preceding claims, wherein each of the insulating layer (128) and the gate electrode layer (134) comprises a thickness from 5 nm to 1 µm.

9. An assembly comprising at least two of the vertical field-effect transistors (110) according to any one of the preceding claims being located on top of each other.

10. The assembly according to the preceding claim, wherein two adjoining vertical field-effect transistors (110) located on top of each other share a common electrode layer (112, 122).

11. A method for manufacturing a vertical field-effect transistor (110), comprising the following steps:
a) providing a first electrode layer (112);
b) preparing an arrangement by placing a semiconductor layer on top of the first electrode layer (112) and, subsequently, placing a second electrode layer (122) on top of the semiconductor layer, wherein the semiconductor layer is a porous semiconductor layer (118);
c) growing an insulating layer (128), the insulating layer comprising a dielectric layer and/or a ferroelectric layer, in a manner that first exposed areas (130) of the porous semiconductor layer (118), an accessible exposed area (142) of the first electrode layer (112) and an accessible exposed area (144) of the second electrode layer (122) within a first window (132) is covered by the insulating layer (128); and
d) growing a metallically conducting layer configured to form a gate electrode layer (134) covering second exposed areas (136) of the insulating layer (128) within a second window (138);
wherein the insulating layer (128) is grown in a manner that the gate electrode layer (134) remains physically and electrically separated from the first electrode layer (112), the second electrode layer (122), and the semiconductor layer (118).

12. The method according to the preceding claim, wherein the porous semiconductor layer (118) is placed on top of the first electrode layer (112) or wherein the porous semiconductor layer (118) is obtained by treating a precursor layer being placed on top of the first electrode layer (112).

13. The method according to any one of the two preceding claims, wherein the insulating layer (128) is grown by exposing the arrangement to an atomic layer deposition (ALD) technique or a chemical vapor deposition (CVD) technique.

14. A use of a vertical field-effect transistor (110) according to any one of the preceding claims referring to the vertical field-effect transistor (110) in high-density device integration and high-power electronics.

15. Electronics comprising at least one vertical field-effect transistor (110) according to any one of the preceding claims referring to the vertical field-effect transistor (110).
